# EUROPEAN PATENT APPLICATION

(11) **EP 4 818 723 A1**
(43) Date of publication of application: **07.10.2026**
(21) Application number: 25822677.8
(22) Date of filing: 04.04.2025
(51) Int. Cl.: G01R 31/392, G01R 31/3842, G01R 31/396, G01R 19/165, G01R 19/12

(54) **BATTERY MANAGEMENT DEVICE, BATTERY MANAGEMENT METHOD, AND BATTERY SYSTEM**

(30) Priority: 11.06.2024 KR 20240075530; 18.12.2024 KR 20240190097
(71) Applicant: LG Energy Solution, Ltd., Seoul 07335 (KR)
(72) Inventor: LIM, Sung Chul, Daejeon 34122 (KR); KWON, Yo Han, Daejeon 34122 (KR); HONG, Do Young, Daejeon 34122 (KR)
(74) Representative: Goddar, Heinz J.
(86) International application number: PCT/KR2025/095169
(87) International publication number: WO 2025/259078

(57) **Abstract**

According to some embodiments, a battery management device includes an interface configured to acquire battery data of a battery while charging/discharging cycles are repeated, and a controller configured to calculate a charging current change amount based on a difference between a first current value in a constant current charging section and a second current value at a reference point in time in a constant voltage charging section based on the battery data for each charging/discharging cycle and diagnose a state of the battery based on a variation of the charging current change amount according to an increase in the number of charging/discharging cycles.

## Description

### TECHNICAL FIELD

### Cross-reference to Related Applications

This application claims priority from Korean Patent Application Nos. 10-2024-0190097, filed on December 18, 2024, and 10-2024-0075530, filed on June 11, 2024, the disclosures of which are incorporated by reference herein.

### Technical Field

Embodiments disclosed in this document relate to a battery management device, a battery management method, and a battery system.

### BACKGROUND ART

Recently, research and development on secondary batteries have been actively conducted. Here, secondary batteries are batteries that can be charged and discharged, and may be interpreted as including both conventional Ni/Cd batteries, Ni/MH batteries, and recent lithium-ion batteries. Among secondary batteries, lithium ion batteries may have higher energy density than conventional Ni/Cd batteries, Ni/MH batteries, etc. and may be manufactured to be small and lightweight, and thus may have high usability as a power source for mobile devices. Recently, the scope of use of the secondary batteries has expanded to include a power source for electric vehicles, and the secondary batteries are attracting attention as a next-generation energy storage medium.

The state of health (SOH) may indicate the remaining life of the battery, the current state of performance, etc. In the related art, the SOH may be calculated by a method such as current integration, etc. and variables such as battery cell resistance may be required for the SOH calculation. Auxiliary indicators that can estimate SOH in a different way from the conventional method may be required, in that SOH cannot be calculated when some of the variables cannot be measured.

### DISCLOSURE OF THE INVENTION

### TECHNICAL PROBLEM

Embodiments disclosed in this document provide a battery management device, a battery management method, and a battery system capable of estimating an SOH value in a different way from the conventional SOH calculation method based on a constant current-constant voltage (CC-CV) charging cycle.

The technical problems of the embodiments disclosed in this document are not limited to the technical problems mentioned above, and other technical problems that are not mentioned may be clearly understood by those skilled in the art from the descriptions below.

### TECHNICAL SOLUTION

According to some embodiments, a battery management device includes an interface configured to acquire battery data of a battery while charging/discharging cycles are repeated and a controller configured to calculate a charging current change amount based on a difference between a first current value in a constant current charging section and a second current value at a reference point in time in a constant voltage charging section based on the battery data for each charging/discharging cycle and diagnose a state of the battery based on a variation of the charging current change amount according to an increase in the number of charging/discharging cycles.

According to some embodiments, the controller may be configured to calculate a decrease rate of a charging current in the constant voltage charging section of each charging/discharging cycle, and select the reference point in time in the constant voltage charging section based on the decrease rate of the charging current.

According to some embodiments, the controller may be configured to estimate a current change amount pattern by fitting the variation of the charging current change amount according to an increase in the number of charging/discharging cycles, and diagnose the state of the battery based on the current change amount pattern.

According to some embodiments, the controller may be configured to estimate the current change amount pattern based on at least one of a linear function and an exponential function between the number of charging/discharging cycles and the charging current change amount.

According to some embodiments, the controller may be configured to divide sections corresponding to the plurality of charging/discharging cycles into exponential sections and linear sections based on a graph form of the charging current change amount with respect to the number of charging/discharging cycles, and estimate the current change amount pattern based on a combination of an exponential function corresponding to the exponential section and a linear function corresponding to the linear section.

According to some embodiments, the controller may be configured to predict an SOH value of the battery based on the charging current change amount.

According to some embodiments, the controller may be configured to estimate a variation pattern of the instantaneous change rates of the charging current for the charging/discharging cycles based on an instantaneous change rate of the charge current at a start point in time of the constant voltage charging section of each charging/discharging cycle and diagnose the state of the battery based on the variation pattern of the instantaneous change rates.

According to some embodiments, a battery management method includes acquiring battery data of a battery while charging/discharging cycles are repeated, calculating a charging current change amount based on a difference between a first current value in a constant current charging section and a second current value at a reference point in time in a constant voltage charging section based on the battery data for each charging/discharging cycle, and diagnosing a state of the battery based on a variation of the charging current change amount according to an increase in the number of charging/discharging cycles.

According to some embodiments, the calculating of the charging current change amount may include calculating a decrease rate of a charging current in the constant voltage charging section of each charging/discharging cycle, and selecting the reference point in time in the constant voltage charging section based on the decrease rate of the charging current.

According to some embodiments, the diagnosing of the state of the battery may include estimating a current change amount pattern by fitting the variation of the charging current change amount according to an increase in the number of charging/discharging cycles, and diagnosing the state of the battery based on the current change amount pattern.

According to some embodiments, the estimating of the current change amount pattern may include estimating the current change amount pattern based on at least one of a linear function and an exponential function between the number of charging/discharging cycles and the charging current change amount.

According to some embodiments, the estimating of the current change amount pattern may include dividing sections corresponding to the plurality of charging/discharging cycles into exponential sections and linear sections based on a graph form of the charging current change amount with respect to the number of charging/discharging cycles and estimating the current change amount pattern based on a combination of an exponential function corresponding to the exponential section and a linear function corresponding to the linear section.

According to some embodiments, the diagnosing of the state of the battery may include predicting an SOH value of the battery based on the charging current change amount.

According to some embodiments, the diagnosing of the state of the battery may include estimating a variation pattern of the instantaneous change rates of the charging current for the charging/discharging cycles based on an instantaneous change rate of the charge current at a start point in time of the constant voltage charging section of each charging/discharging cycle, and diagnosing the state of the battery based on the variation pattern of the instantaneous change rates.

According to some embodiments, a battery system includes a battery, a power device configured to supply power to the battery or consume power of the battery, and a controller configured to acquire battery data of a battery while charging/discharging cycles are repeated, calculate a charging current change amount based on a difference between a first current value in a constant current charging section and a second current value at a reference point in time in a constant voltage charging section based on the battery data for each charging/discharging cycle, and diagnose a state of the battery based on a variation of the charging current change amount according to an increase in the number of charging/discharging cycles.

### ADVANTAGEOUS EFFECTS

According to the embodiments disclosed in this document, a battery management method, and a battery system capable of estimating an SOH value in a different way from the conventional SOH calculation method based on a constant current-constant voltage (CC-CV) charging cycle.

The technical effects according to the embodiments disclosed in this document are not limited to the effects mentioned above, and other effects not mentioned will be clearly understood by those skilled in the art according to the disclosure of this document.

### BRIEF DESCRIPTION OF THE DRAWINGS

FIG. 1 illustrates components constituting a battery system according to some embodiments.
FIG. 2 illustrates components constituting a battery management device according to some embodiments.
FIG. 3 illustrates constant current-constant voltage (CC-CV) charging cycles according to some embodiments.
FIG. 4 illustrates constant current-constant voltage (CC-CV) charging cycles according to some embodiments.
FIG. 5 illustrates a change amount of a charging current in a constant voltage charging section of a CC-CV charging cycle according to some embodiments.
FIG. 6 illustrates a charging current change pattern in which a change amount of a charging current when charging and discharging cycles proceed is indicated according to some embodiments.
FIG. 7 illustrates steps constituting a battery management method according to some embodiments.

### MODE FOR CARRYING OUT THE INVENTION

Hereinafter, embodiments described in this document are described with reference to the accompanying drawings. However, this is not intended to limit the disclosure of this document to a specific embodiment, but should be understood to include various modifications, equivalents, and/or alternatives of the embodiments described in this document.

Embodiments of this document and the terms used therein are not intended to limit the technical features described in this document to a specific embodiment, but should be understood to include various modifications, equivalents, or alternatives of the embodiment. In connection with the description of the drawings, similar reference numerals may be used for similar or related components. The singular form of a noun corresponding to an item may include a single or a plurality of said items, unless the context clearly dictates otherwise.

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof. Terms such as "first", "second", "firstly", "secondly", "A", "B", "(a)", or "(b)" may be used merely to distinguish one component from another, and do not limit the components in any other respect (e.g., importance or order) unless specifically stated otherwise.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner or wirelessly), or indirectly (e.g., through a third component).

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices (e.g., smartphones), or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to embodiments disclosed in this document, each of the components (e.g., modules or programs) described above may include a single or plurality of entities, and some of the plurality of entities may be separated and placed in other components. According to embodiments disclosed in this document, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to embodiments disclosed in this document, the operations performed by a module, program, or other component may be performed sequentially, in parallel, repeatedly, or heuristically, or one or more of the operations may be performed in a different order, omitted, or performed by being added with one or more other operations.

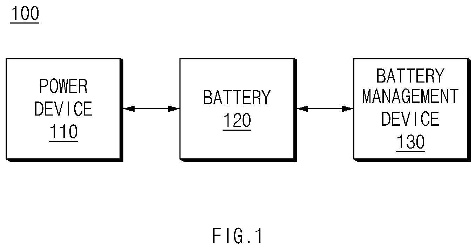

FIG. 1 may illustrate components constituting a battery system according to some embodiments.

Referring to FIG. 1, a battery system 100 may include a power device 110, a battery 120, and a battery management device 130. However, it is not limited thereto, and some configurations may be omitted from the battery system 100, or other general-purpose configurations may be further included in the battery management system 100.

The power device 110 may discharge the battery 120 while consuming power, or charge the battery 120 while providing power to the battery 120. The power device 110 may include a power consumption device and/or a power supply device. According to an embodiment, the power consumption device may include a mobility device such as an electric vehicle (EV), a hybrid electric vehicle (HEV), or an electric bike. The mobility device may also operate as a power supply device to charge the battery 120. The mobility device may use the power of the battery 120 to drive a motor or charge the battery 120 with power generated through regenerative braking. According to the embodiment, the power supply device may include a charger/discharger for charging or discharging the battery 120. The charger/discharger may apply a charging current, a charging voltage, a discharging current, and/or a discharging voltage to the battery 120 based on a given profile or cycle.

The battery 120 may include one or more battery packs, etc. to be managed by the battery system 100. Each battery pack of the battery 120 may include a plurality of battery modules, and each battery module may include a plurality of battery cells. According to the embodiment, the battery 120 may be mounted on various types of mobility devices, energy storage systems (ESSs), battery exchange stations (BSSs), etc.

The battery management device 130 may perform operations for diagnosis, management, and/or control of the battery 120. The battery management device 130 may acquire battery data of the battery 120, diagnose or manage the state of the battery 120 based on the acquired battery data, and control the operation of the battery 120. According to the embodiment, the battery management device 130 may include a battery management system (BMS) configured with the battery 120 in an on-board manner, and/or an external device placed remotely from the battery 120 in an off-board manner. The external device may include a charger of a battery charging station, a battery diagnosis device, a cloud computing server, a user terminal device of a user of the battery 120, etc.

The battery system 100 may further include a management server. The management server may manage the results of management, diagnosis, and/or control of the battery management device 130 through a database, etc. The management server may exchange data with the battery management device 130 in a wired/wireless communication manner. If a defect in the battery 120 is diagnosed or its lifespan is predicted, the results may be transmitted to the management server and recorded in a database. According to the embodiment, the battery management device 130 may perform diagnosis operations by executing battery management software, and the management server may provide update information of the battery management software to the battery diagnosis device 130.

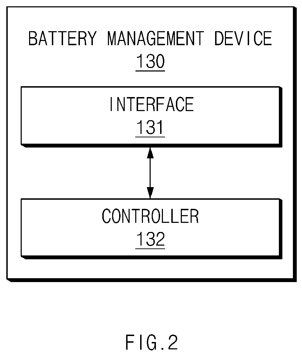

FIG. 2 may illustrate components constituting a battery management device according to some embodiments.

Referring to FIG. 2, the battery management device 130 may include an interface 131 and a controller 132. However, it is not limited thereto, and some configurations may be omitted from the battery management device 130, or other general-purpose configurations may be further included in the battery management device 130.

The interface 131 may acquire battery data of the battery 120. According to the embodiment, the interface 131 may include a communication unit configured to receive the battery data and/or a sensor unit configured to measure the battery data. According to the embodiment, when the battery management device 130 is implemented in an off-board form, the communication unit may receive battery data in a manner of wired data communication, wireless data communication, etc. Alternatively, when the battery management device 130 is implemented in an on-board form, the sensor unit may be configured to measure values of voltage, current, temperature, resistance, etc. from the battery 120.

The controller 132 may have a structure for executing instructions that implement operations of the battery management device 130. The controller 132 may be implemented as an array of multiple logic gates or a general-purpose microprocessor for processing various operations, and may be configured as a single processor or a plurality of processors. For example, the controller 132 may be implemented in the form of at least one of a microprocessor, a CPU, a GPU, and an AP.

The controller 132 may operate in conjunction with a memory configured to store various data, instructions, mobile applications, computer programs, etc. The memory may be configured separately or integrally with the controller 132. The controller 132 may execute instructions stored in the memory to process various operations. For example, the memory may be implemented in the form of a nonvolatile device such as a ROM, a PROM, an EPROM, an EEPROM, a flash memory, a PRAM, an MRAM, an RRAM, and an FRAM, or a volatile device such as a DRAM, an SRAM, an SDRAM, and a PRAM, and may be implemented in the form of a HDD, an SSD, an SD, a Micro-SD, or a combination thereof.

The interface 131 may be configured to acquire battery data of the battery 120 while the charging/discharging cycles are repeated. For example, each charging/discharging cycle may include a charging cycle and a discharging cycle, and the charging cycle may include a constant current-constant voltage (CC-CV) charging cycle. The CC-CV charging until the voltage of the battery 120 reaches a particular value may include a constant current section for charging the battery 120 at a constant current and a constant voltage section for maintaining a voltage of a particular value until a charging completion point in time. For example, the battery data may include a constant current charging current value and a current value at the charging completion point in time in each CC-CV cycle, and the current value at the charging completion point in time may mean a current value at a point in time at which constant voltage charging is completed.

The controller 132 may be configured to calculate a change amount of the charging current in the constant voltage charging section of the battery based on the battery data for each charging/discharging cycle. The change amount of the charging current may mean a difference between a current value at a start point in time and a current value at an end point in time of the constant voltage charging section. The current value at the start point in time of the constant voltage charging section may mean a constant current value in the constant current charging section. The current value at the start point in time of the constant voltage charging section may be maintained constant even if the charging/discharging cycle proceeds, but the current value at the end point in time of the constant voltage charging section may be changed when the charging/discharging cycle proceeds. According to the embodiment, as the charging/discharging cycle proceeds, the current value at the end point in time of the constant voltage charging section may increase, and therefore, as the charging/discharging cycle proceeds, the change amount of the charging current may decrease.

The controller 132 may be configured to estimate a charging current change pattern in which the change amount of the charging current when the charging/discharging cycles proceed is indicated. If the charging/discharging cycles proceed, the change amount of the charging current may be changed, and a pattern of change may be estimated. For example, a variation of the change amount of the charging current according to the progress of the charging/discharging cycle may be expressed by a specific functional equation through data fitting, curve fitting, etc. Data/curve fitting may be performed through the least square method, etc.

The controller 132 may be configured to diagnose a state of the battery 120 based on the charging current change amount pattern. As the charging/discharging cycle of the battery 120 proceeds, the performance and lifespan may decrease. When the performance and the lifespan decrease, the change amount of the charging current in the constant voltage charging section of the CC-CV charging may be reduced. That is, a difference between a current value at a start point in time and a current value at an end point in time of the constant voltage charging section may be relatively large at an early stage of the lifespan of the battery 120, and the difference may be relatively small at a later stage of the lifespan thereof. Considering this phenomenon, the state of the battery 120 may be diagnosed based on the charging current change amount pattern. According to the embodiment, the controller 132 may provide a notification to the user of the battery 120 and/or the power usage device 110 based on the state of the battery 120, or may stop the operation of the battery 120. The stoppage of operation may include short-circuiting and/or opening of the battery 120.

According to the embodiment, in the charging/discharging cycles, the battery 120 may be charged by constant current constant voltage (CC-CV) charging, and the controller 132 may be configured to calculate the change amount of the charging current of each charging and discharging cycle based on a difference between a first current value in the constant current charging section and a second current value at a reference point in time in the constant voltage charging section. The charging current in the constant voltage charging section may decrease, so that a current value in the constant current charging section may be greater than a current value at a reference point in time in the constant voltage charging section. The current value of the constant current charging section may be a current value at a start point in time of the constant voltage charging section. The reference point in time may be selected as a point in time most suitable for estimating the charging current change amount pattern within the constant voltage charging section. For example, the reference point in time may be selected based on a change rate/slope of the charging current in the constant voltage charging section. According to the embodiment, the reference point in time may be an end point in time of the constant voltage charging section.

According to the embodiment, the controller 132 may be configured to calculate a charging current slope indicating a reduction rate of the charge current in the constant voltage charge period of each charging/discharging cycle, and select a reference point in time in the constant voltage charging section based on the charging current slope. The charging current may have a high rate of decrease at an early stage of the constant voltage charging section, and may have a low rate of decrease at a later stage of the constant voltage charging section. According to the embodiment, a point in time at which a decrease rate or a slope of the charging current becomes lower than a threshold value may be selected as the reference point in time. When the decrease rate or slope of the charging current does not reach the threshold value, the end point in time of the constant voltage charging section may be selected as the reference point in time. When the reference point in time is determined, an change amount between the charging current at the start point in time of the constant voltage charging section and the charging current at the reference point in time may be calculated for each charging/discharging cycle.

According to the embodiment, the controller 132 may be configured to estimate the charge current change amount pattern by fitting the variation of the change amount of the charging current as the number of charging/discharging cycles increases. For example, when the number of charging/discharging cycles is n, the number of change amount values of the charging current may also be n. The n change amount values may be plotted on a two-dimensional x-y graph, and the function that best represents these values may be estimated with the charging current change amount pattern. The data fitting for estimating the charging current change amount pattern may be based on a least squares method or the like.

According to the embodiment, the controller 132 may be configured to estimate the charging current change amount pattern based on at least one of a linear function and an exponential function with respect to the number of charging/discharging cycles and the change amount of the charging current. For example, for the number of cycles x and the current change amount y, a linear function such as y = ax + b may be fitted in the charging current change amount pattern, or an exponential function such as y = ae^{x} + b may be fit in the charging current change amount pattern. Alternatively, a combination of a linear function and an exponential function may be utilized, and various functions such as a polynomial function of a second order or higher, a logarithmic function, and a trigonometric function may be utilized.

According to the embodiment, the controller 132 may be configured to divide sections corresponding to the plurality of charging/discharging cycles into exponential sections and linear sections based on a graph form of a charging current change amount with respect to the number of charging/discharging cycles, and estimate the change amount pattern of the charging current based on a combination of an exponential function corresponding to the exponential section and a linear function corresponding to the linear section. For example, in a two-dimensional graph of the number of charging/discharging cycles and the change amount of the charging current, the exponential section and the linear section may be distinguished based on whether there is a change in the slope of the graph. In the latter half of the plurality of charging/discharging cycles, the change in the slope of the graph may be less than a threshold value, which may cause the two-dimensional graph to be close to the linear section. A more accurate estimation of the charging current change amount pattern may be made possible by dividing the exponential section and the linear section.

According to the embodiment, the controller 132 may be configured to predict an SOH value of the battery 120 based on the charging current change amount pattern. When charging and discharging of the battery 120 are repeated, degradation of performance or lifespan thereof may occur, and the SOH value may decrease. In addition, the change amount of the charging current may be decreased by repetition of charging and discharging. Considering these together, it may be possible to estimate the SOH value of the battery 120 based on the change amount of the charging current. For example, a current change amount value after m cycles may be derived with reference to the charging current change amount pattern, and an SOH value at a future point in time may be estimated based on the value. According to the embodiment, the controller 132 may be configured to predict the SOH value of the battery 120 based on a proportional relationship in which the SOH value increases as the change amount of the charging current according to the charging current change amount pattern increases. A large change amount of charging current may mean that fewer charging/discharging cycles have proceeded, which may mean that less degradation in the lifespan and/or performance of the battery 120 has occurred. Therefore, the change amount of the charging current and the SOH value may have a proportional relationship with each other. According to the embodiment, the proportional relationship between the change amount of the charging current and the SOH value may be expressed as a linear relationship, which is expressed as a first-order function, an exponential function relationship, a logarithmic function relationship, a polynomial function relationship, or a combination thereof.

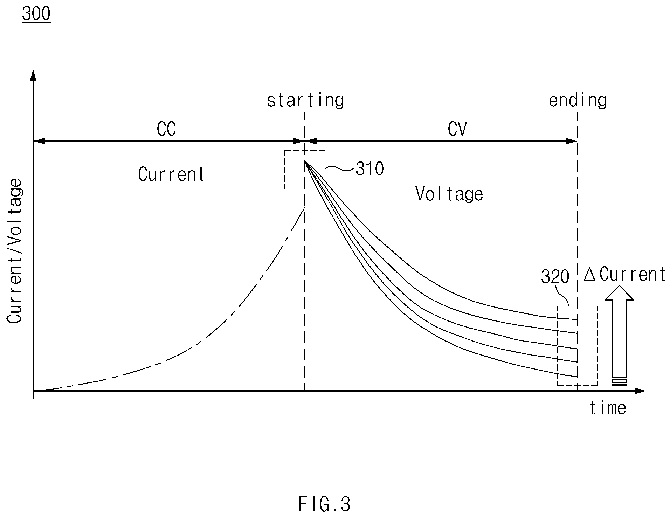

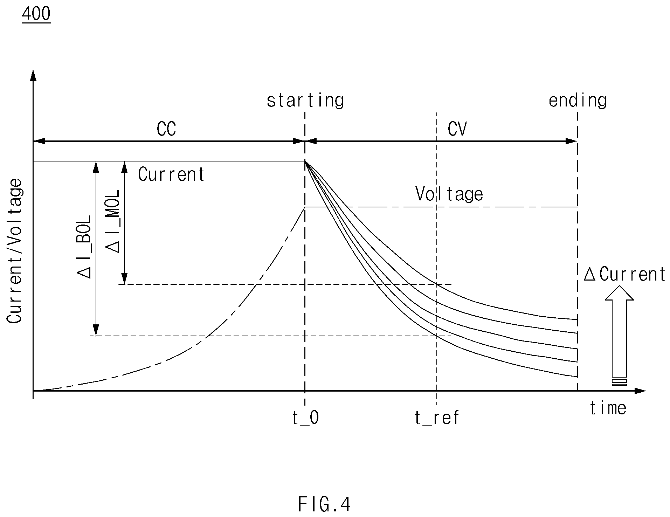

According to the embodiment, the controller 132 may be configured to estimate a change pattern of instantaneous change rates of the charging current for the charging and discharging cycles based on an instantaneous change rate of the charging current at the start point in time of the constant voltage charging section of each charging/discharging cycle, and diagnose the state of the battery 120 based on the change pattern of the instantaneous changes rates. For example, as in FIG. 3 or FIG. 4 to be described below, as the number of charging/discharging cycles increases, the magnitude of the instantaneous change rate of the charging current at the start point in time of the constant voltage charging section may decrease. Considering this, when the state of the battery 120 is good or the SOH of the battery 120 is high, the charging current may change steeply at the start point in time of the constant voltage charging section, and when the state of the battery 120 is poor or the SOH thereof is low, the charging current may change gradually at the start point in time of the constant voltage charging section.

According to the embodiment, the controller 132 may be configured to adjust the state of the battery 120 based on a change state of the charging voltage in the constant current charging section of the current charging/discharging cycle. As the number of charging/discharging cycles increases, the degradation of the battery 120 may proceed and the internal resistance thereof may increase. The amount and/or speed at which the voltage of the battery 120 increases in the constant current charging section may be increased due to an increase in internal resistance. Considering this, the state and/or SOH of the battery 120 may be more accurately diagnosed. For example, when a voltage increase amount or a voltage increase rate of the constant current charging section is excessively high in the current charging/discharging cycle based on the BOL point in time, the battery 120 may be diagnosed as a poor state or the SOH of the battery 120 may also be measured to be low.

According to the embodiment, similarly to the manner of diagnosing the state of the battery 120 based on the charging current change amount pattern in the constant voltage charging section, it may also be possible to diagnose the state of the batteries 120 based on the charging voltage change amount pattern in the constant current charging section. For example, the controller 132 may be configured to calculate the change amount of the charging voltage in the constant current charging section of the battery 120 based on battery data for each charging/discharging cycle, estimate the charging voltage change amount pattern indicated by the change amount of the charging voltage when the charging/discharging cycles proceed, and diagnose the state of the battery 120 based on the charging voltage change amount pattern.

FIG. 3 illustrates constant current-constant voltage (CC-CV) charging cycles according to some embodiments.

Referring to FIG. 3, a graph 300 illustrating the constant current-constant voltage (CC-CV) charging cycles may be illustrated. The horizontal axis of the graph 300 may represent the time during which one cycle is running, and the vertical axis thereof may represent the voltage and current.

In the graph 300, a plurality of charging cycles may be displayed together. The plurality of charging cycles may be CC-CV charging cycles. Even if the number of cycles increases, a current value in the constant current charging section may be constant, and a voltage value in the constant voltage charging section may be constant. When the number of cycles increases, the current behavior in the constant voltage charging section may vary.

As at a start point in time 310 of constant voltage charging, as the number of cycles increases, a charging current slope may become gentler and an absolute value of the charging current slope may become smaller. In addition, as at an end point in time 320 of the constant voltage charging, as the number of cycles increases, the charging current value at the end point in time of charging may increase, and the change amount of the charging current may decrease. An SOH value of a current point in time and/or a future point in time of the battery 120 may be predicted based on a change in behavior of the start point in time 310 and the end point in time 320.

FIG. 4 illustrates constant current-constant voltage (CC-CV) charging cycles according to some embodiments.

Referring to FIG. 4, a graph 400 illustrating a process of measuring a change amount of a charging current using a reference point in time t_ref may be illustrated.

In the graph 400, a change amount ΔI of the charging current in a section from a start point in time t_0 to a reference point in time t_ref of a constant voltage charging section may be measured. A change amount ΔI of the charging current may decrease as the number of charging and discharging cycles increases or as the use of the battery 120 mounted on the mobility device accumulates. For example, as illustrated in the graph 400, a change amount ΔI_MOL of the charging current at the middle-of-lifespan (MOL) point in time may be smaller than a change amount ΔI_BOL of the charging current at the beginning-of-lifespan (BOL) point in time. In this way, the state of the battery 120 and/or the SOH of the battery 120 may be diagnosed using the change amount ΔI of the charging current.

The reference point in time t_ref may be selected as the most suitable point in time for estimating the charging current change amount pattern within the constant voltage charging section. For example, as illustrated in the graph 400, the reference point in time t_ref may be selected as a point in time at which the magnitude of the change rate/slope of the charging current becomes smaller than a threshold value. In this case, only the section in which the magnitude of the change rate/slope of the charging current is greater than the threshold value may be utilized as a section for measuring the change amount ΔI of the charging current. According to this, the charging current change amount pattern appearing in the change amount ΔI of the charging current may be set to be more clearly and distinguishably. That is, according to an appropriate setting of the reference point in time t_ref, the degree of scattering, dispersion, etc. of the values of the change amount ΔI of the plurality of charging currents corresponding to the plurality of charging/discharging cycles may be further increased.

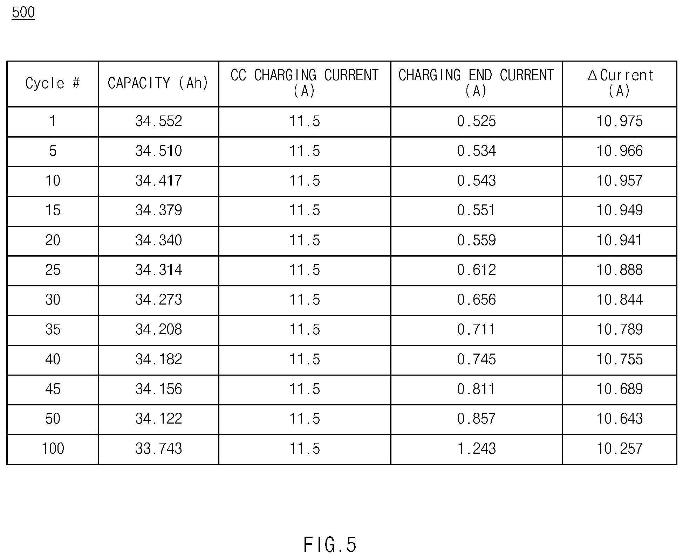

FIG. 5 illustrates a change amount of a charging current in a constant voltage charging section of a CC-CV charging cycle according to some embodiments.

Referring to FIG. 5, a table 500 illustrating the change amount of the charging current in the constant voltage charging section of the CC-CV charging cycle may be illustrated.

The table 500 may represent current values at the end point in time of charging for 12 cycle order values. The value of CC charging current may be the same in all cycles. The change amount ΔCurrent or ΔI of the charging current may be a difference between a value of the CC charging current and a current value at the end point in time of charging. The change amount ΔCurrent of the charging current may decrease as the number of cycles increases. When the change amount ΔCurrent of the charging current is measured based on such data, the number of cycles and the SOH value may be estimated using the measured change amount ΔCurrent.

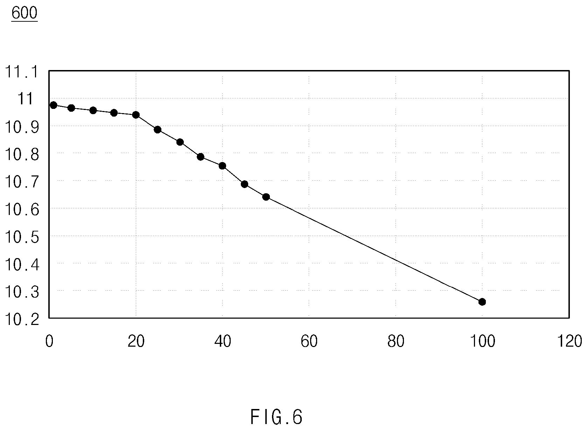

FIG. 6 illustrates a charging current change amount pattern in which the change amount of the charging current when charging/discharging cycles proceed is indicated according to some embodiments.

Referring to FIG. 6, a graph 600 illustrating a charging current change amount pattern indicated by the change amount of the charging current when charging/discharging cycles proceed may be illustrated. The graph 600 may represent data exemplified in table 500.

The horizontal axis of the graph 600 may represent the number of cycles, and the vertical axis may represent the change amount ΔCurrent of the charging current. The data distribution expressed in the graph 600 may be expressed as a specific functional equation through data fitting. The charging current change amount pattern may be derived through data fitting by which the data distribution is expressed as a specific functional equation. When the charging current change amount pattern is used, the number of cycles and the SOH value at any point in time may be predicted based on the change amount ΔCurrent of the charging current at the current point in time.

The graph 600 may indicate a case where the reference point in time t_ref is set as the end point in time of the constant voltage charging section. Alternatively, the reference point in time t_ref may be selected in consideration of the change rate/the magnitude of the slope of the charging current. For example, when the reference point in time t_ref is selected as a point in time at which the change rate/magnitude of the slope of the charging current becomes smaller than a threshold value, the degree of scattering of values of the change amount ΔI of the charging current may be larger than the degree of scattering in the graph 600. When the degree of scattering is larger, due to the clear division of data, the accuracy of expressing a specific functional equation through data fitting may be higher.

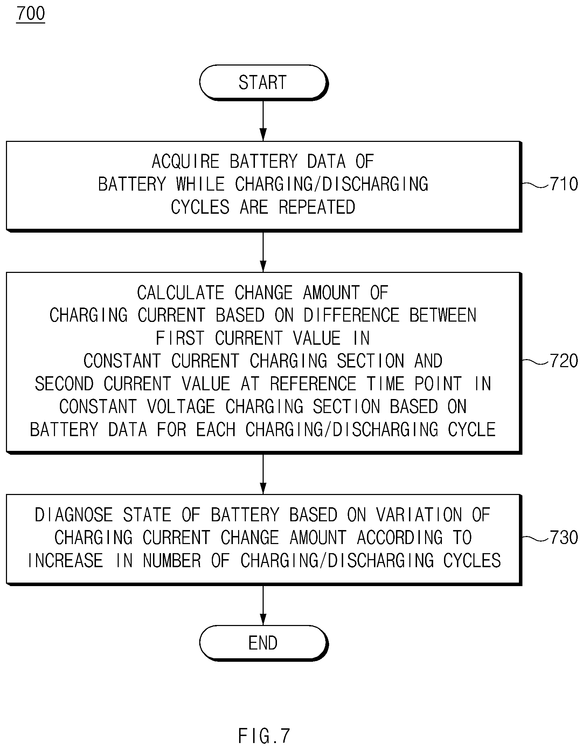

FIG. 7 illustrates steps of configuring a battery management method according to some embodiments.

Referring to FIG. 7, a battery management method 700 may include steps 710 to 730. However, the present disclosure is not limited thereto, and some steps may be omitted or other general-purpose steps may be added, and the steps of the battery management method 700 may be executed in an order different from the order illustrated.

The battery management method 700 may be composed of steps that are processed in time series in the battery management device 130. Therefore, even if the content is omitted below, the content described above for the battery management device 130 may be equally applied to the battery management method 700.

Steps 710 to 730 of the battery management method 700 may be performed by the interface 131 and the controller 132 of the battery management device 130.

In step 710, the battery management device 130 may perform acquiring battery data of a battery while charging/discharging cycles are repeated.

In step 720, the battery management device 130 may perform calculating a charging current change amount based on a difference between a first current value in a constant current charging section and a second current value at a reference point in time in a constant voltage charging section based on the battery data for each charging/discharging cycle.

In step 730, the battery management device 130 may perform diagnosing a state of the battery based on a variation of a charging current change amount according to an increase in the number of charging/discharging cycles.

According to the embodiment, the battery management method 700 may be implemented in the form of a computer program stored in a computer-readable storage medium. That is, the computer program may include instructions for implementing the battery management method 700, and the instructions of the program may be stored in the computer-readable storage medium. The computer program may include a mobile application.

According to the embodiment, the computer-readable storage medium may include magnetic media such as a hard disk, a floppy disk, and a magnetic tape, optical media such as a CD-ROM, a DVD, magneto-optical media such as a floptical disk, and a hardware device specifically configured to store and execute computer program instructions such as a ROM, a RAM, a flash memory, etc. The computer program instructions may include a machine language code generated by a compiler and a high-level language code that may be executed by a computer using an interpreter, etc.

The terms "include," "configure," or "have" described above, unless specifically stated to the contrary, mean that the corresponding component may be included therein, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an illustrative description of the technical idea disclosed in this document, and those skilled in the art to which the embodiments disclosed in this document belong may make various modifications and variations without departing from the essential characteristics of the embodiments disclosed in this document. Accordingly, the embodiments disclosed in this document are not intended to limit the technical ideas of the embodiments disclosed in this document, but rather to describe them, and the scope of the technical ideas disclosed in this document is not limited by these embodiments. The scope of protection of the technical ideas disclosed in this document should be interpreted by the scope of the claims below, and all technical ideas within the equivalent scope should be interpreted as being included in the scope of the rights of this document.

### [Description of Symbols]

100: Battery system 110: Power device
120: Battery 130: Battery management device
131: Interface 132: Controller

## Claims

1. A battery management device comprising:
an interface configured to acquire battery data of a battery while charging/discharging cycles are repeated; and
a controller configured to:
calculate a charging current change amount based on a difference between a first current value in a constant current charging section and a second current value at a reference point in time in a constant voltage charging section based on the battery data for each charging/discharging cycle; and
diagnose a state of the battery based on a variation of the charging current change amount according to an increase in the number of charging/discharging cycles.

2. The battery management device of claim 1, wherein the controller is configured to:
calculate a decrease rate of a charging current in the constant voltage charging section of each charging/discharging cycle; and
select the reference point in time in the constant voltage charging section based on the decrease rate of the charging current.

3. The battery management device of claim 1, wherein the controller is configured to:
estimate a current change amount pattern by fitting the variation of the charging current change amount according to an increase in the number of charging/discharging cycles; and
diagnose the state of the battery based on the current change amount pattern.

4. The battery management device of claim 3, wherein the controller is configured to estimate the current change amount pattern based on at least one of a linear function and an exponential function between the number of charging/discharging cycles and the charging current change amount.

5. The battery management device of claim 4, wherein the controller is configured to:
divide sections corresponding to the plurality of charging/discharging cycles into exponential sections and linear sections based on a graph form of the charging current change amount with respect to the number of charging/discharging cycles; and
estimate the current change amount pattern based on a combination of an exponential function corresponding to the exponential section and a linear function corresponding to the linear section.

6. The battery management device of claim 1, wherein the controller is configured to predict an SOH value of the battery based on the charging current change amount.

7. The battery management device of claim 1, wherein the controller is configured to:
estimate a variation pattern of the instantaneous change rates of the charging current for the charging/discharging cycles based on an instantaneous change rate of the charge current at a start point in time of the constant voltage charging section of each charging/discharging cycle; and
diagnose the state of the battery based on the variation pattern of the instantaneous change rates.

8. A battery management method comprising:
acquiring battery data of a battery while charging/discharging cycles are repeated;
calculating a charging current change amount based on a difference between a first current value in a constant current charging section and a second current value at a reference point in time in a constant voltage charging section based on the battery data for each charging/discharging cycle; and
diagnosing a state of the battery based on a variation of the charging current change amount according to an increase in the number of charging/discharging cycles.

9. The battery management method of claim 8, wherein the calculating of the charging current change amount includes:
calculating a decrease rate of a charging current in the constant voltage charging section of each charging/discharging cycle; and
selecting the reference point in time in the constant voltage charging section based on the decrease rate of the charging current.

10. The battery management method of claim 8, wherein the diagnosing of the state of the battery includes:
estimating a current change amount pattern by fitting the variation of the charging current change amount according to an increase in the number of charging/discharging cycles; and
diagnosing the state of the battery based on the current change amount pattern.

11. The battery management method of claim 10, wherein the estimating of the current change amount pattern includes estimating the current change amount pattern based on at least one of a linear function and an exponential function between the number of charging/discharging cycles and the charging current change amount.

12. The battery management method of claim 11, wherein the estimating of the current change amount pattern includes:
dividing sections corresponding to the plurality of charging/discharging cycles into exponential sections and linear sections based on a graph form of the charging current change amount with respect to the number of charging/discharging cycles; and
estimating the current change amount pattern based on a combination of an exponential function corresponding to the exponential section and a linear function corresponding to the linear section.

13. The battery management method of claim 8, wherein the diagnosing of the state of the battery includes predicting an SOH value of the battery based on the charging current change amount.

14. The battery management method of claim 8, wherein the diagnosing of the state of the battery includes:
estimating a variation pattern of the instantaneous change rates of the charging current for the charging/discharging cycles based on an instantaneous change rate of the charge current at a start point in time of the constant voltage charging section of each charging/discharging cycle; and
diagnosing the state of the battery based on the variation pattern of the instantaneous change rates.

15. A battery system comprising:
a battery;
a power device configured to supply power to the battery or consume power of the battery; and
a controller configured to acquire battery data of a battery while charging/discharging cycles are repeated, calculate a charging current change amount based on a difference between a first current value in a constant current charging section and a second current value at a reference point in time in a constant voltage charging section based on the battery data for each charging/discharging cycle, and diagnose a state of the battery based on a variation of the charging current change amount according to an increase in the number of charging/discharging cycles.
